(19) Europäisches Patentamt
European Patent Office
Office européen des brevets

(11) Publication number: **0 117 269 B1**

(12) **EUROPEAN PATENT SPECIFICATION**

(45) Date of publication of patent specification: **25.05.88**

(51) Int. Cl.⁴: **H 05 K 9/00,** C 09 D 5/38

(21) Application number: **83101922.9**

(22) Date of filing: **26.02.83**

(54) **Coating composition.**

(43) Date of publication of application:
**05.09.84 Bulletin 84/36**

(45) Publication of the grant of the patent:
**25.05.88 Bulletin 88/21**

(84) Designated Contracting States:
**DE FR GB**

(56) References cited:
**DE-A-3 021 439**
**FR-A-2 204 674**
**NL-A-7 907 129**

**CHEMICAL ABSTRACTS, vol. 85, no. 2, 12th July 1976, pages 60-61, no.6809x, Columbus, Ohio, USA**

(73) Proprietor: **GENERAL ELECTRIC COMPANY**
**1 River Road**
**Schenectady New York 12305 (US)**

(72) Inventor: **Watchko, George Russel**
**57 Highland Street**
**Reading Massachusetts 01807 (US)**

(74) Representative: **Michelotti, Giuliano**
**c/o SAIC BREVETTI S.r.l. Viale Bianca Maria 15**
**I-20122 Milano (IT)**

**The file contains technical information submitted after the application was filed and not included in this specification**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 117 269 B1

**Description**

The invention relates to an electromagnetic wave attenuating coating with an electrically conductive additive dispersed therein, as known e.g. from GB—A—2035843.

Electromagnetic wave interference (EMI) or radio frequency interference (RFI) results from the operation of various electronic devices. Many devices such as electronic memories are extremely sensitive to EMI or RFI pollution which can deprogram memories and has the potential for ruining the circuitry and thus rendering the device useless. Historically this was not a problem to industry because of metallic housing that acted as a shield and the fact that sensitive electronic devices were not in wide use. The use of plastics in place of metal for the manufacture of housings for electronic devices results in a structure that allows electromagnetic waves to flow virtually unimpeded through the device. The Federal Communications Commission has established regulations to limit the amount of electromagnetic radiation that may be emitted by an electronic device (FCC Docket No. 20780). This regulation divides computing devices into two broad categories of those intended for business (Class A) and those for home use (Class B). The limits are defined by an electromagnetic wave having a given field strength or less at a given distance throughout a given frequency range. The industry has met the standard imposed by the FCC regulations by using vacuum metalizing or silver filled paints which are quite costly.

Other industry standards for these products are VDE German standard 0871/6.78; the proposed SAE AIR 1499; and U.S. Department of Health MDS—201—004.

Many solvent based coatings have been used for this reason and they have included electrically conductive additives such as nickel, copper and silver. The term plastic is used to refer to those polymeric materials commonly used for housing for electronic apparatus such as polyphenylene ethers, polycarbonates, polyacrylates, polysulfones, polystyrenes, flame retardant polystyrenes, epoxy resins and the like.

One prior art approach to coating compositions for plastic substrates, containing electrically conductive flakes according to CHEMICAL ABSTRACTS vol. 85, No. 2, July 12th, 1976, pages 60—61, No. 6809 x "RFI/EMI shielding for SMC and BMC" PROC. ANNU. CONF. REINF. PLAST./COMPOS. INST., SOC. PLAST. IND. 1976, 31, 7—D, 10, is disclosed in GB—A—2 035 843 at page 1 lines 50—75. These compositions work rather well as regards the aderence to plastic substrates and the shielding from electromagnetic radiation, however, to prepare them, are used dispersions of conductive flakes in resins and these resins must be solved in organic solvents, as hydrocarbons, preferably low boiling halogenated hydrocarbons as methylene chloride or trichloroethylene.

The applicant has discovered a method for making a coating composition containing electrically conductive flakes that result in a coating composition that adheres to plastic substrates and is capable of shielding sensitive electronic components from electromagnetic radiation.

Thus, the primary object of the present invention is to provide a composition that is capable of blocking electromagnetic radiation and also a coating composition that adheres to plastic substrates.

The invention provides a method of preparing a novel electromagnetic wave attenuating composition, containing a film forming curable coating composition and an electrically conductive additive, characterized in that the electrically conductive additive is dispersed under low shear conditions in a film forming curable composition consisting of an aqueous resin dispersion including a surface active agent.

The nature of the curable film forming composition is not critical, although it is necessary to select materials which are capable of fully wetting the conductive flake composition, so that an adherent coating having fully dispersed conductive flakes is obtained. As water based systems are used, it is preferred to utilize, as a wetting agent, an anionic surfactant (i.e. surface active agent) as an additive to the composition.

Suitable curable film forming coating compositions include aqueous dispersions of acrylic and urethane resins. These aqueous compositions include surface active agents to ensure that the conductive flakes are completely "wetted". The acrylic based curable film forming composition may include carboxylated acrylic resins such as styrene-acrylic copolymers (Neocryl A-621 from Polyvinyl Chemical Co. of Wilmington, Mass.) or other commercially available acrylics such as Rhoplex WL-91 (Rohm & Haas, Philadelphia, Pa) Ucar 4431 (Union Carbide Co., New York, NY) or Stacryl 200 (Stanley Chemicals, Co.). The urethane resins include the aqueous aliphatic urethane that may be prepared using procedures that are described in the Encyclopedia of Polymer Science and Technology, Vol. II, pp. 555—558. Briefly these materials are prepared by reaction of a diisocyanate with a polyol or water. Suitable diisocyanates are of the formula OCN—R—NCO when R is an organic radical. Suitable R groups include $(CH_2)n$, wherein n is an integer of from 1 to 8. Specific examples of the diisocyanates include hexamethylene diisocyanates; methylcyclohexene diisocyanate; lysine diisocyanates; bis(2-isocyanatoethyl)fumarate and bis(2-isocyanatoethyl) carbonate.

A preferred aliphatic urethane is Neorez R-960 which is available from Polyvinyl Chemical Industries, 730 Main Street, Wilmington, Massachusetts 01887.

If an anionic surfactant is employed, the particular anionic surfactant is not critical to the invention and various materials such as sodium lauryl sulfate, sodium alkyl sulfonates, alkyl aryl sulfonates, sodium 2,2-dinaphthyl-methane-6,6'-disulfonate and the like may be used. Other anionic surfactants are listed in McCutcheon's Detergents and Emulsifiers.

To impart resistance to polar solvents such as methanol, an additive to the urethane base composition

may be utilized which is a trifunctional aziridine compound, which is a derivative of ethyleneimine, having the formula

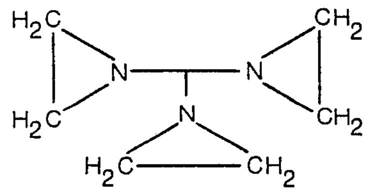

This is available from Cordoba Chemical Co., Sacramento, California under the tradename XAMA-7.

The electrically conductive additive may include nickel, copper, iron, silver, chromium tin, aluminum, zinc or carbon materials which possess the morphology which permits the formation of an electrically conductive layer when from 10—60 volume percent of the additive is dispersed in a curable film forming coating composition. The preferred additive is nickel in the form of flakes. The term electrically conductive is used to define a film surface resistivity of less than about 75 ohms/square according to a test that is described hereinafter. The preferred ranges of electrical resistivity are between 50 and 0,05 ohms/square and especially preferred are resistivities of 0,1 to 0,7 ohms/square. The electrical resistivity may be correlated with the surface characteristics that are necessary to block electromagnetic radiation and it is a useful test to determine the suitability of a given composition useful for electromagnetic wave attenuation.

The compositions of the invention preferably include from about 40 to 80 parts by weight of a 20—40 by weight aqueous dispersion of the curable film forming composition from about 20 to 60 parts by weight of the electrical conductive additive. The trifunctional aziridine may be added at from 0,5 to 5 parts by weight of composition, if desired and if a surfactant is present, it may comprise from 10—20 parts by weight of a 20—50% solids aqueous dispersion of the surfactant.

The manner in which the compositions of the invention are prepared as well as the morphology of the electrically conductive additive are very important to the production of a coating which can be successfully attenuate electromagnetic radiation. The use of a high shear mixing apparatus should be avoided when the electrically conductive additive is dispersed in the curable film forming composition. The use of a high shear apparatus tends to break down the particle size of electrically conductive additives thus reducing the degree of overlap and tangential contact between particles of the additive and the additive and the resultant loss of electrical conductivity. The use of a low shear mixing procedure avoids the breakdown of the electrically conductive particles and the proper type of a low shear mixing step can be selected based on the degree of shear which produces a coating having the proper degree of electrical conductivity and electromagnetic attenuation.

The curing conditions for the composition will depend on the nature of the curable film forming compositions. The preferred compositions are aqueous based materials that may be dried at ambient conditions. If desired, heat, e.g. of 22—65°C (72—150°F) may be used to accelerate the cure of these film forming compositions.

The term ohm/square is a unitless term that is based on a test which measures the resistance between two silver clad dimes that are placed apart on the test surface at a distance equal to the diameter of a dime. A Simpson meter is then used to determine the resistance.

## Example 1

A composition was prepared from 16.23 parts by weight of 21% by weight solids of an aqueous dispersion anionic surfactant[1] derived from an ammonium salt of a polycarboxylic acid; 24.35 parts by weight of a 60% by weight aqueous dispersion of a styrene acrylic copolymer[2] having an acid number of 30. The styrene acrylic copolymer dispersion and the water were added all together and agitation was provided by a laboratory Hockmeyer using a 76.2 mm (3") bore blade at 2000 rpm. The anionic surfactant was added slowly (one minute) to avoid shocking the styrene acrylic copolymer out of the aqueous dispersion. Mixing was then continued for about 60 minutes. The composition was removed from the Hockmeyer and placed under low shear agitation using a standard laboratory impeller utilised to create surface movement. Thereafter 51.61 parts by weight of nickel flake[3] (33:1 flake morphology ratio; 1.3 g/cm$^3$ density; 1.2 micron average flake thickness) were added and were blended into the film forming base with said low shear agitation for 15—20 minutes. Preparation of the composition in this manner provides for a minimal destruction of the nickel flake morphology. The composition was coated onto various surfaces that were tested for adhesion, surface resistivity and attenuation of electromagnetic radiation. The results are reported in Table 1.

---

1 Tamol 165 Rohm and Haas, Philadelphia, PA
2 Neocryl A-621 Polyvinyl Chemical Co.
3 Ni-HCA-1 Novamet, Wyckoff, N.J.

TABLE 1

| | Polyphenylene oxide-rubber modified polystyrene[1] | | Polyphenylene oxide-rubber modified polystyrene[1] (foamed) | Polycarbonate[2] (foamed) | Polycarbonate[2] |
|---|---|---|---|---|---|
| Adhesion[3] | 100% | 100% | 100% | 100% | 100% |
| Initial | 100% | 100% | 100% | 100% | 100% |
| 56 days at 82°C (180°F) | 100% | 100% | 100% | 100% | 100% |
| 56 days at 90% rel hum & 35°C (95°F) | 100% | 100% | 100% | 100% | 100% |
| Film Surface Resistivity[4] | | | | | |
| Initial | 0.3 ohm/sq | 0.2 ohm/sq | 0.3 ohm/sq | 0.1 ohm/sq | 0.5 ohm/sq |
| 56 days at 82°C (180°F) | 0.7 ohm/sq | 0.5 ohm/sq | 0.3 ohm/sq | 0.1 ohm/sq | 0.9 ohm/sq |
| 3 months at RT | 0.5 ohm/sq | 0.6 ohm/sq | 0.3 ohm/sq | 0.1 ohm/sq | 0.5 ohm/sq |
| Attentuation[5] | | | 50dB | | |

Panel Preparation — VM&P Naphtha wipe
Application — Conventional Spray Equipment
Flash — 30 min. at R.T.
Cure — 30 min. at 65°C (150°F) or 12 hours at R.T.
Film Build — 30.5—45.7 microns (1.2—1.8 mils)

1 Noryl
2 Lexan
3 Crosshatch
4 Run with 3 dimes with center one removed and resistivity run with Simpson meter
5 Measure drop in decibles of a 110 dB signal from 1 kiloHertz to 1 GigaHertz on FN-215. Result is not substrate dependent and can be translated to any substrate where adhesion and film resistivity are comparable

Example 2

A composition was prepared from 16.6 parts by weight of a 20% by weight solids of an aqueous dispersion of the anionic surfactant of Example 1; 83.4 parts by weight of a 38% by weight aqueous dispersion of an aliphatic polyurethane[1] and 50.83 parts by weight of the nickel flake of example 1. The composition was prepared using the same procedure of Example 1 and the cured film had excellent adhesion on foamed and unfoamed polycarbonate compositions as well as on foamed polyphenylene oxide rubber modified high impact styrene compositions. The resistivity was less than 1 ohm/square.

Example 3

The composition of Example 2 was modified by the inclusion of a 3% by weight of a trifunctional aziridine[2] compound to give the composition improved resistance to polar solvents such as methanol. This composition was cured into a film having a resistivity of less than 1 ohm/square.

Example 4

This example compares the results of the applicant's process with a high shear process. The composition of Example 1 was blended with varying amounts of artificial graphite[3]. The resistivities of cured films were determined and are reported in Table 2.

---

1 NeoRez 960 Polyvinyl Chemical Corp.
2 XAMA-7; Cordoba Chemical Company
3 Asbury Graphite Mills, Asbury, N.J.

TABLE 2

| Artificial Graphite | High Shear[1] | Low Shear[2] |
|---|---|---|
| (wt%) | (ohm/sq) | (ohm/sq) |
| 35 | 1000 | 62 |
| 40 | 120 | 18 |
| 60 | 35 | 5 |

This data demonstrates the profound effect that the mixing procedure of the invention has on the resistivity of the cured films.

---

1 Centrifugation in Cowles at about 2000 rpm
2 Procedure of Example 1

**Claims**

1. A method for forming an electromagnetic wave attenuating composition, containing a film forming curable coating composition and dispersed therein an electrically conductive additive, characterized in that, the electrically conductive additive is dispersed under low shear conditions in a film forming curable coating composition consisting of an aqueous resin dispersion including a surface active agent.

2. A method as defined in claim 1 characterized in that the electrically additive is flaked nickel.

3. A method as claimed in claim 1 characterized in that the curable film forming composition is based on an acrylic resin.

4. A method as defined in claim 1 characterized in that the curable film forming composition is based on an aliphatic urethane resin.

5. A method as defined in claim 3 or 4, characterized in that the curable film forming agent includes an anionic surface active agent.

6. A composition for forming an electromagnetic wave barrier on a plastic surface comprising a curable film forming composition in which an electrically conductive additive has been dispersed, characterized in that it is an aqueous composition, and includes a surface active agent, the additive being dispersed under low shear conditions.

7. A composition as defined in claim 6, characterized in that the coating composition includes an acrylic resin and flaked nickel.

8. A composition as defined in claim 6 characterized in that the coating composition includes an aliphatic urethane resin and flaked nickel.

9. A composition as defined in claim 7 or 8 characterized in that the composition contains an anionic surface active agent.

10. A plastic substrate that has been coated with the cured composition of claim 6.

**Patentansprüche**

1. Verfahren zur Ausbildung einer elektromagnetische Wellen dämpfenden Zusammensetzung aus einer filmbildenden härtbaren Überzugsmasse und darin dispergiertem elektrisch leitendem Zusatzstoff, gekennzeichnet dadurch, daß der elektrisch leitende Zusatzstoff unter niedrigen Scherbedingungen in einer filmbildenden härtbaren Überzugsmasse aus einer wässrigen Harzdispersion, die ein oberflächenaktives Mittel einschließt, dispergiert wird.

2. Verfahren nach Anspruch 1, dadurch gekennzeichnet, daß der elektrisch leitende Zusatzstoff geflocktes Nickel ist.

3. Verfahren nach Anspruch 1, dadurch gekennzeichnet, daß die härtbare filmbildende Zusammensetzung auf einem Acrylharz basiert.

4. Verfahren nach Anspruch 1, dadurch gekennzeichnet, daß die härtbare filmbildende Zusammensetzung auf einem aliphatischen Urethanharz basiert.

5. Verfahren nach Anspruch 3 oder 4, dadurch gekennzeichnet, daß das härtbare filmbildende Mittel ein anionisches oberflächenaktives Mittel umfaßt.

6. Zusammensetzung zur Ausbildung einer Barriere für elektromagnetische Wellen auf einer Kunststoffoberfläche enthaltend eine härtbare filmbildende Zusammensetzung, in der ein elektrisch leitfähiger Zusatzstoff dispergiert worden ist, dadurch gekennzeichnet, daß es eine wässrige Zusammensetzung ist, die ein oberflächenaktives Mittel enthält, und der Zusatzstoff unter niedrigen Scherbedingungen dispergiert worden ist.

7. Zusammensetzung nach Anspruch 6, dadurch gekennzeichnet, daß die Überzugsmasse ein Acrylharz und geflocktes Nickel einschließt.

8. Zusammensetzung nach Anspruch 6, dadurch gekennzeichnet, daß die Überzugsmasse ein aliphatisches Urethanharz und geflocktes Nickel einschließt.

9. Zusammensetzung nach Anspruch 7 oder 8, dadurch gekennzeichnet, daß die Zusammensetzung ein anionisches oberflächenaktives Mittel enthält.

10. Kunststoffträger, der beschichtet worden ist, mit der gehärteten Zusammensetzung nach Anspruch 6.

**Revendications**

1. Procédé de formation d'une composition atténuant les ondes électromagnétiques, contenant une composition de revêtement durcissable filmogène dans laquelle est dispersé un additif électriquement conducteur, caractérisé en ce qu'on disperse l'additif électriquement conducteur dans des conditions de cisaillement peu élevé, dans une composition de revêtement durcissable filmogène constituée par une dispersion aqueuse de résine contenant un agent tensioactif.

2. Procédé selon la revendication 1, caractérisé en ce que l'additif électriquement conducteur est constitué par des paillettes de nickel.

3. Procédé selon la revendication 1, caractérisé en ce que la composition filmogène durcissable est à base d'une résine acrylique.

4. Procédé selon la revendication 1, caractérisé en ce que la composition filmogène durcissable est à base d'une résine d'uréthanne aliphatique.

5. Procédé selon la revendication 3 ou 4, caractérisé en ce que l'agent filmogène durcissable comprend un agent tensioactif anionique.

6. Composition pour la formation d'une barrière aux ondes électromagnétiques sur une surface en matière plastique, comprenant une composition filmogène durcissable dans laquelle on a dispersé un additif électriquement conducteur, caractérisée en ce qu'il s'agit d'une composition aqueuse, et en ce qu'elle contient un agent tensio-actif, l'additif étant dispersé dans des conditions de cisaillement peu élevé.

7. Composition selon la revendication 6, caractérisée en ce que la composition de revêtement comprend une résine acrylique et des paillettes de nickel.

8. Composition selon la revendication 6, caractérisée en ce que la composition de revêtement comprend une résine d'uréthanne aliphatique et des paillettes de nickel.

9. Composition selon la revendication 7 ou 8, caractérisée en ce que la composition contient un agent tensio-actif anionique.

10. Substrat en matière plastique que l'on a revêtu avec la composition durcie selon la revendication 6.